# FASCICULE DE BREVET EUROPEEN

(11) **EP 0 818 825 B1**
(45) Date de publication et mention de la délivrance du brevet: **27.10.2004**
(21) Numéro de dépôt: 97410073.7
(22) Date de dépôt: 09.07.1997
(51) Int. Cl.: H01L 27/08, H01L 29/74, H01L 29/10

(54) **Assemblage monolithique de thyristors à cathode commune**
Monolithische Montage von Thyristoren mit gemeinsamer Kathode
Monolithic assembly of thyristors with common cathode

(30) Priorité: 12.07.1996 FR 9608972
(43) Date de publication de la demande: 14.01.1998
(73) Titulaire: STMicroelectronics S.A., 92120 Montrouge (FR)
(72) Inventeur: Simmonet, Jean-Michel, 37000 Tours (FR)
(74) Mandataire: de Beaumont, Michel

(56) Documents cités:
- EP-A- 0 709 891
- FR-A- 2 697 674
- US-A- 4 032 958
- PATENT ABSTRACTS OF JAPAN vol. 8, no. 13 (E-222), 20 Janvier 1984 & JP 58 176972 A (NIPPON DENKI K.K.), 17 Octobre 1983,
- PATENT ABSTRACTS OF JAPAN vol. 4, no. 4 (E-164), 12 Janvier 1980 & JP 54 144887 A (MITSUBISHI DENKI K.K.), 11 Décembre 1979,
- PATENT ABSTRACTS OF JAPAN vol. 7, no. 33 (E-157), 9 Février 1983 & JP 57 186365 A (NIPPON DENKI K.K.), 16 Novembre 1982,
- PATENT ABSTRACTS OF JAPAN vol. 1, no. 152 (E-71), 7 Décembre 1977 & JP 52 091659 A (TOSHIBA CORP), 8 Février 1977,
- PATENT ABSTRACTS OF JAPAN vol. 10, no. 201 (E-419), 15 Juillet 1986 & JP 61 044464 A (TOSHIBA CORP), 4 Mars 1986,
- PAUL ROBERT: "Dictionnaire alphabétique et numérique de Langue Française", 1992, DICTIONNAIRES LE ROBERT,

## Description

La présente invention concerne un assemblage monolithique de thyristors à cathode commune et à gâchette unique.

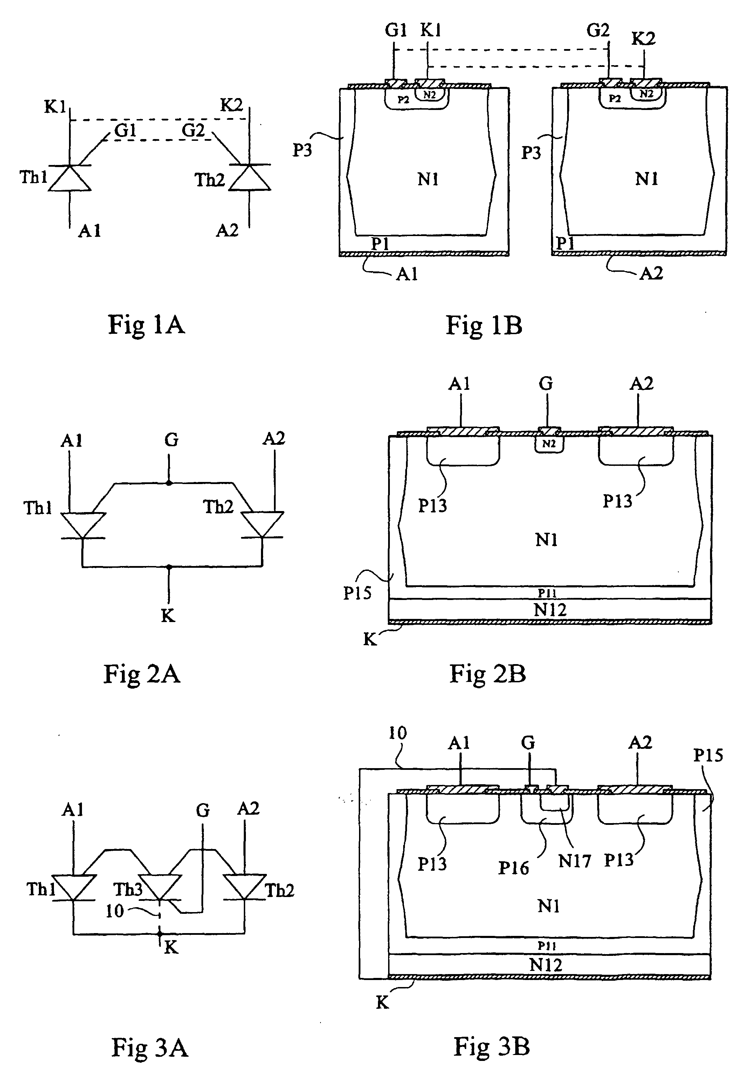

Les thyristors les plus courants sont des thyristors à gâchette de cathode. La figure 1A représente deux tels thyristors Th1 et Th2. Une réalisation classique de ces thyristors est illustrée schématiquement, en coupe, en figure 1B. Chaque thyristor est constitué à partir d'un substrat N1 de type N dont la face arrière ou inférieure est occupée par une couche P1 de type P. Du côté de la face avant ou supérieure, on trouve une région de gâchette de cathode P2 dans laquelle est formée une région de cathode N2. Pour améliorer la tenue en tension et éviter divers problèmes liés aux découpes et aux brasures, la périphérie des thyristors est généralement occupée par un caisson P3 de type P, formé par diffusion profonde à partir des faces inférieure et supérieure.

De tels thyristors se prêtent bien à des montages en anode commune. En ce cas, les couches P1 de chacun des thyristors sont constituées d'une seule et même couche formée sur la face arrière du substrat N1. Cette face arrière peut alors être montée par brasure sur un radiateur.

Toutefois, la réalisation de montages à cathode commune pose problème. Il n'est pas possible de réaliser sur la face avant une métallisation de cathode unique montée sur un radiateur car alors on court-circuiterait les métallisations de gâchette. Il faut donc prévoir des structures dans lesquelles la borne de gâchette se trouve sur la face opposée à la face de cathode. Un assemblage de thyristors discrets à cathode commune est décrit dans JP-A-58176972.

Une première solution connue est illustrée en figure 2A sous forme de schéma. Elle consiste à former des thyristors à gâchette d'anode. Comme le représente la figure 2B, la structure du thyristor est modifiée. En partant toujours d'un substrat N1 de type N, on trouve sur la face arrière de ce substrat une couche P11 de type P puis une couche N12 de type N. Du côté de la face avant sont formées des régions d'anode P13 de type P et une région N14 fortement dopée de type N de prise de contact de gâchette. Un caisson P15 de type P relie la périphérie de la couche P11 à la surface supérieure.

Un avantage de cette structure est qu'elle utilise de nombreuses étapes de fabrication communes avec la structure de la figure 1B. En effet, les étapes initiales de formation du caisson P15 puis de la couche P11 sont identiques aux étapes de formation du caisson P3 puis de la couche P1 de la structure de la figure 1B. Un inconvénient de cette structure est que la commande se fait par une tension de gâchette référencée à la tension d'anode, qui est une tension élevée si c'est la cathode qui est reliée à la masse. Un autre inconvénient est que cette gâchette doit être polarisée négativement par rapport à l'anode alors que, dans les circuits électriques courants, il est généralement plus facile de générer une tension de commande positive qu'une tension de commande négative. Un autre inconvénient est que, de façon générale, les thyristors à gâchette d'anode sont moins sensibles que les thyristors à gâchette de cathode.

Une deuxième solution connue est illustrée en figure 3A sous forme de schéma. Elle permet d'améliorer le circuit de la figure 2A en ce qui concerne d'une part sa sensibilité et d'autre part la possibilité de déclenchement par une tension de gâchette positive référencée par rapport à la cathode et non par rapport à l'anode. Dans cette solution, les gâchettes d'anode des thyristors Th1 et Th2 sont reliées à l'anode d'un thyristor Th3 dont la cathode est reliée aux cathodes communes des thyristors Th1 et Th2. Une connexion est prise sur la gâchette de cathode pour constituer la borne de gâchette positive G.

Comme le représente la figure 3B, chacun des thyristors Th1 et Th2 a la même structure anode-cathode que les thyristors de la figure 2B. La différence réside dans la structure de commande qui est constituée d'une région P16 formée du côté de la face supérieure dans laquelle est formée une région N17. La région N17 est reliée par un fil 10 à la cathode. La région P16 est revêtue d'une métallisation reliée à une borne de gâchette G. L'inconvénient de cette structure est que sa surface est nécessairement importante car il faut prévoir une distance de garde notable entre les régions P13 (au potentiel de l'anode) et la région P16 (au potentiel de la cathode) pour assurer une tenue en tension suffisante. De plus, la connexion entre une borne de la face avant et la face arrière par un fil 10 complique le montage.

On notera que, dans les réalisations des figures 2B et 3B, le caisson P15 a uniquement pour rôle de protéger la périphérie de la jonction assurant la tenue en tension directe entre le substrat N1 et la couche P11, en effet, cette tenue en tension serait réduite si cette jonction débouchait sur une face latérale. Le caisson P15 n'est connecté à aucune borne.

Un objet de la présente invention est de prévoir un assemblage de thyristors à cathode commune et à gâchette unique évitant les problèmes liés aux thyristors de l'art antérieur, cet assemblage étant réalisé en utilisant des technologies classiques et déjà éprouvées.

Cet objet de la présente invention est atteint par un assemblage monolithique de thyristors selon la revendication 1.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 3A, décrites précédemment, représentent divers schémas de circuit d'assemblages de thyristors ;
les figures 1B à 3B, décrites précédemment, représentent schématiquement des vues en coupe de composants semiconducteurs mettant en oeuvre respectivement les circuits des figures 1A à 3A ;
la figure 4A représente un schéma de circuit d'un composant;
la figure 4B représente une vue en coupe schématique d'un composant;
la figure 5A représente le schéma d'un thyristor ;
la figure 5B représente un mode de montage classique appliqué à un thyristor selon la présente invention ;
la figure 6 représente une vue de dessus d'un masque de mur de diffusion latéral utilisé selon un mode de réalisation de la présente invention ;
les figures 7A et 7B représentent respectivement une vue en coupe et une vue de dessus d'une variante d'une structure selon la présente invention ; et
les figures 8 à 11 illustrent, en coupe, des variantes de montage d'un composant selon la présente invention.

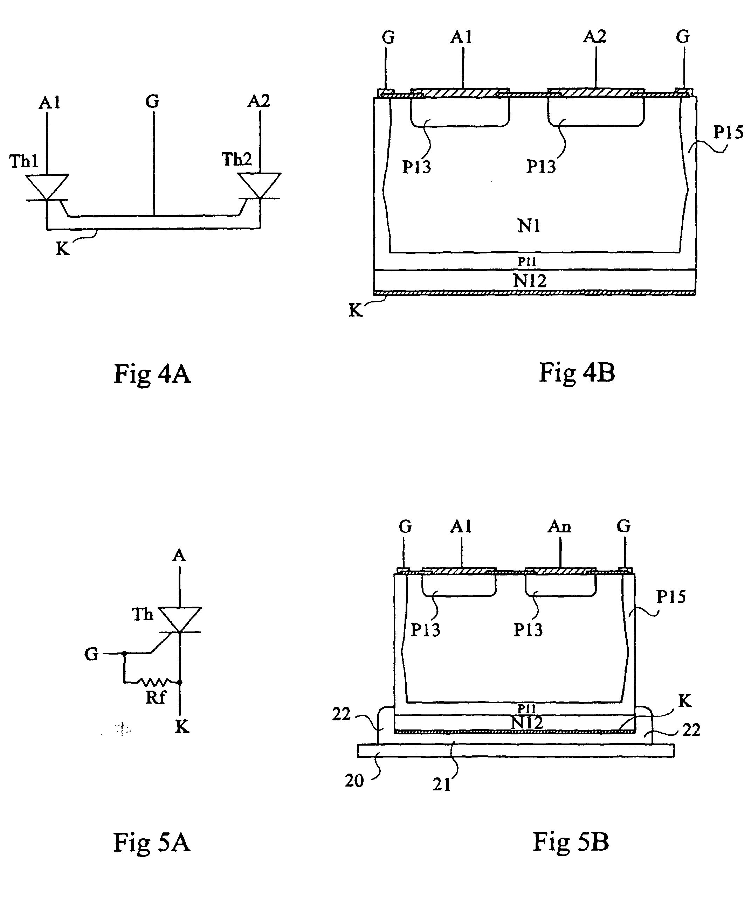

Le composant de la figure 4A prévoit d'assembler deux thyristors Th1 et Th2 par une cathode commune avec une gâchette unique constituant une gâchette de cathode. Bien entendu, pour pouvoir avoir une cathode commune, le contact sur la gâchette de cathode est repris sur la face opposée à la cathode.

La figure 4B représente une vue en coupe schématique d'un composant selon la figure 4A.

En ce qui concerne la structure anode-cathode, ce composant est identique aux composants des figures 2B et 3B. Comme eux, il comprend du côté de la face inférieure d'un substrat N1 une couche P11 de gâchette de cathode et une couche N12 de cathode et sur la face supérieure des régions d'anode P13. Comme précédemment également, la périphérie du composant est entourée d'un caisson P15 reliant la région P11 à la surface supérieure.

En ce qui concerne le procédé de fabrication, on notera que, à partir du substrat N11, on forme d'abord les diffusions profondes destinées à former le caisson P15 puis l'on forme, éventuellement simultanément, les régions P11 et P13 et enfin on forme la région N12 sur la face arrière.

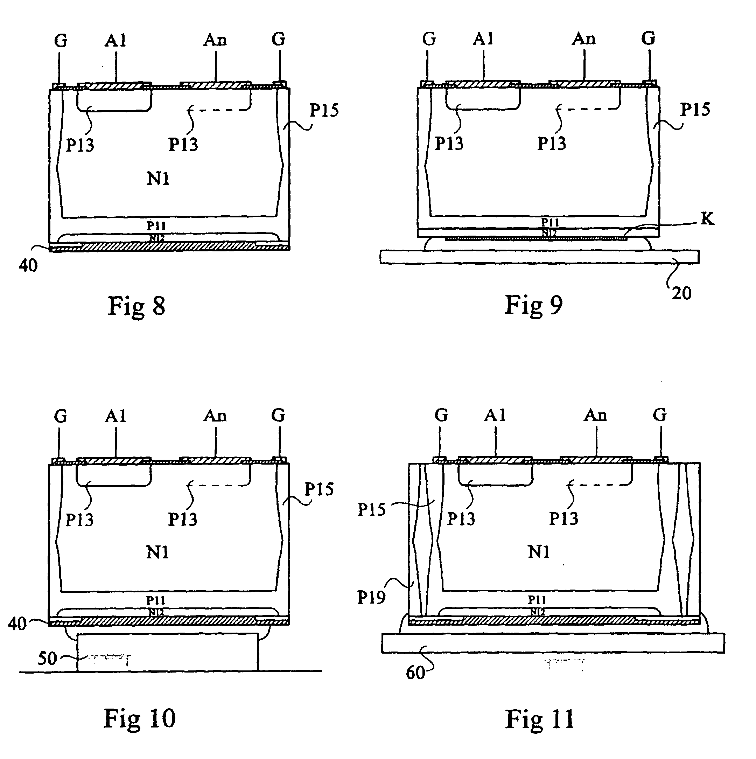

Contrairement aux composants des figures 2B et 3B, le composant selon la figure 9B ne comprend pas de structure spécifique de gâchette. Au lieu de cela, un contact de gâchette est formé sur la surface supérieure du caisson P15. Ainsi, le composant selon la présente invention présente tous les avantages de chacun des composants des figures 2B et 3B sans leurs inconvénients. Notamment, il est commandable par une tension de gâchette positive par rapport à la tension de cathode et sa surface peut être réduite. Sa sensibilité peut être élevée du fait qu'il s'agit d'une structure à gâchette de cathode. De plus, du fait de sa grande similarité avec celles des figures 2B et 3B, cette structure peut être fabriquée d'une façon parfaitement compatible avec les procédés classiques.

Toutefois, la structure très simple de la figure 4B présente un risque de défaut.

En effet, la figure 5A représente sous forme symbolique un thyristor. La sensibilité de ce thyristor dépend notamment de la résistance gâchette-cathode Rf. Cette résistance gâchette-cathode correspond à la résistance de fuite entre les couches P11 et N12. Cette résistance est susceptible d'être détériorée pour deux causes principales. Premièrement, dans la structure de la figure 4B, le sciage de composants individuels à partir d'une tranche où sont formés de nombreux composants identiques coupe la jonction P11-N12. Il est connu qu'un tel sciage peut dégrader la qualité de la jonction et introduire une résistance parasite. Une autre source de dégradation de la résistance résulte du montage classique illustré en figure 5B. La métallisation de cathode K est montée sur une embase 20, classiquement par une couche de brasure 21. Or, il existe un risque non-négligeable pour que la brasure déborde latéralement au moins sur des portions de la périphérie en formant des remontées de brasure désignées par les références 22, ce qui provoque des courts-circuits localisés de la jonction P11-N12. Ces deux causes de dégradation de jonction interviennent de façon particulièrement néfaste dans la structure selon l'invention où le contact de gâchette est pris par le caisson et se raccorde à la couche de gâchette de cathode précisément aux emplacements où il risque de se produire des défauts.

Ainsi, la présente invention prévoit d'associer à la structure illustrée en figure 4B des moyens pour réduire l'influence de défauts de jonction entre la couche de cathode et la couche de gâchette de cathode ou des moyens pour réduire la probabilité de survenance de tels défauts.

Selon un premier mode de réalisation de la présente invention, il est prévu une structure particulière du caisson P15.

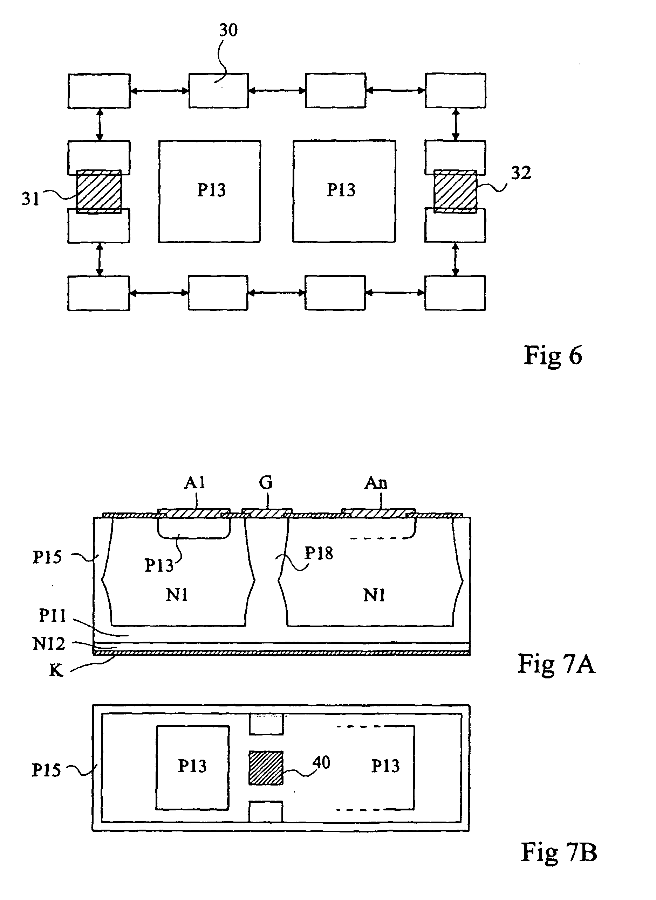

Ce caisson est formé non pas par l'intermédiaire d'un masque périphérique continu mais, comme le représente en vue de dessus la figure 6, par l'intermédiaire d'un masque comprenant des ouvertures voisines 30 en regard sur les faces supérieure et inférieure. Ainsi, au fur et à mesure que la diffusion progresse dans le sens de l'épaisseur, elle s'étend latéralement et la région P15 se ferme mais en comprenant alternativement des veines verticales plus dopées et moins dopées. La métallisation de gâchette est disposée à des emplacements 31 et 32 correspondant à deux thyristors Th1 et Th2. Ainsi, s'il existe un défaut localisé sur la périphérie de la jonction entre les couches P11 et N12, la probabilité pour que ce défaut se trouve en regard de la veine par laquelle se fait la conduction vers la couche inférieure est réduite. En conséquence, dans un lot de fabrication, on obtient un nombre réduit de composants à sensibilité de gâchette dégradée.

Les figures 7A et 7B représentent, en coupe et en vue de dessus, une variante de réalisation de la présente invention dans laquelle les thyristors individuels sont isolés par des murs intermédiaires P18. Ces murs P18 sont formés de façon discontinue comme le mur périphérique P15 de la figure 6 et une zone centrale de ces murs P18 est revêtue d'une métallisation de gâchette 40. Alors, il est certain que cette métallisation ne peut se trouver en regard d'un défaut de périphérie et l'influence d'éventuels défauts de qualité de jonction à la périphérie devient négligeable.

Les modes de réalisation des figures 6 et 7 étaient destinés à pallier l'influence d'éventuels défauts de périphérie de la jonction entre les couches P11 et N12. Selon un autre mode de réalisation de l'invention, on cherche à réduire ou même à supprimer ces défauts de périphérie. Des exemples de moyens pour améliorer la périphérie de jonction sont illustrés en figures 8 à 11.

Dans le mode de réalisation de la figure 8, la couche N12 au lieu de s'étendre sur toute la surface inférieure est localisée par un masque de silice 40 et la métallisation de cathode est formée sur cette région N12. Cette structure présente notamment l'avantage d'éviter l'apparition de défauts de jonction liés à la découpe. Toutefois, il existe encore un risque que des remontées de brasure court-circuitent les régions P11 et N12.

Dans le mode de réalisation de la figure 9, la métallisation de cathode K est localisée au centre du composant et l'on évite ainsi les risques de défaut de brasure en ne supprimant toutefois pas les défauts liés à la découpe en périphérie de jonction.

Dans le mode de réalisation de la figure 10, la couche de cathode est localisée comme dans le cas de la figure 8 et en outre on utilise une embase comportant un bossage 50 d'étendue plus petite que la surface inférieure du composant. Alors, on évite les détériorations éventuelles de jonction liées au sciage et à des remontées de brasure. Ceci se fait évidemment au coût d'un montage plus élevé.

Dans le mode de réalisation de la figure 11, on utilise une structure à double caisson périphérique, un caisson P19 étant formé au-delà du caisson P15. Alors, avec une localisation de la couche de cathode, on évite tout risque de défaut lié au sciage de la puce ou à une remontée de brasure.

Bien entendu, la présente invention est susceptible de diverses variantes et modifications qui apparaîtront à l'homme de métier. Notamment, on pourra apporter aux diverses structures de thyristors les perfectionnements et modifications classiques, par exemple la prévision de courts-circuits d'émetteur.

## Revendications

1. Assemblage monolithique de thyristors à cathode commune et à gâchette unique comprenant :
un substrat (N1) de type N faiblement dopé,
une pluralité de régions d'anode (P13) de type P, du côté de la face avant, revêtues de métallisations d'anode (A),
une couche de gâchette de cathode (P11) de type P, du côté de la face arrière du substrat,
une couche de cathode (N12) de type N du côté de la face arrière de la couche de gâchette de cathode, revêtue d'une métallisation de cathode (K),
un caisson périphérique de type P (P15) s'étendant de la face avant à ladite couche de gâchette de cathode,
**caractérisé en ce que** le caisson comporte, dans la direction de son extension, des zones alternativement plus et moins dopées s'étendant transversalement au substrat, des métallisations de gâchette (31, 32) étant formées sur des portions de la face supérieure dudit caisson.

2. Assemblage monolithique selon la revendication 1, **caractérisé en ce que** le caisson périphérique comprend en outre des murs d'isolement de type P (P18) s'étendant de la face avant à ladite couche de gâchette de cathode séparant les thyristors individuels, lesdits murs d'isolement étant également constitués de portions alternativement plus et moins dopées, les métallisations de gâchette (40) étant disposées sur des régions centrales de ces murs d'isolement.

## Patentansprüche

1. Eine monolithische Anordnung von Tyristoren mit einer gemeinsamen Kathode und einem einzigen Gate wobei folgendes vorgesehen ist:
ein gering dotiertes Substrat (N1) des N-Typs,
eine Vielzahl von Anodenzonen (P13) des P-Typs und zwar auf der vorderen Oberflächenseite (Vorderseite) abgedeckt mit Anoden-Metallisierungen (A),
eine Kathoden-Gate-Schicht (P11) des P-Typs auf der hinteren Oberflächenseite (Rückseite) des Substrats,
eine Kathodenschicht (N12) des N-Typs auf der Rückseite der Kathoden-Gate-Schicht, und zwar beschichtet mit einer Kathoden-Metallisation (K),
eine Umfangsvertiefung (P15) des P-Typs, sich von der Vorderseite zur Kathoden-Gate-Schicht erstreckend,
**dadurch gekennzeichnet, dass** die Vertiefung Gate-Metallisierungen (31, 32) ausgeformt an Teilen der oberen Oberfläche (Oberseite) der Vertiefung aufweist, und zwar in Richtung der Erweiterungsbereiche der Vertiefung, die alternativ mehr oder weniger dotiert sind und sich kreuzweise zum Substrat erstrecken.

2. Eine monolithische Anordnung nach Anspruch 1, **dadurch gekennzeichnet, dass** die Umfangsvertiefung ferner Isoliervertiefungen (P18) des P-Typs aufweist und zwar sich von der Vorderseite der Kathoden-Gate-Schicht, die einzelnen Tyristoren trennt, erstreckend, wobei die Isoliervertiefungen alternativ mehr oder weniger dotierte Teile aufweisen und wobei die Gate-Metallisierungen (40) auf Mittelzonen der Isolierwände angeordnet sind.

## Claims

1. A monolithic assembly of thyristors having a common cathode and a single gate including:
a lightly-doped N-type substrate (N1),
a plurality of P-type anode regions (P13), on the front surface side, covered with anode metallizations (A),
a P-type cathode gate layer (P11) on the rear surface side of the substrate,
an N-type cathode layer (N12) on the rear surface side of the cathode gate layer, coated with a cathode metallization (K),
a peripheral P-type well (P15) extending from the front surface to the cathode gate layer,
**characterized in that** the well includes, in the direction of its extension areas that are alternatively more or less doped extending cross wise of the substrate, gate metallizations (31, 32) being formed on portions of the upper surface of the well.

2. A monolithic assembly according to claim 1, **characterized in that** the peripheral well further comprises P-type insulating wells (P18) extending from the front surface to said cathode gate layer separating the individual thyristors, said insulating walls being also comprised of alternatively more or less doped portions, the gate metallizations (40) being arranged on central regions of the insulating walls.
